# EUROPEAN PATENT APPLICATION

(11) **EP 2 849 341 A1**
(43) Date of publication of application: **18.03.2015**
(21) Application number: 13184606.5
(22) Date of filing: 16.09.2013
(51) Int. Cl.: H03G 9/00

(54) **Loudness control at audio rendering of an audio signal**

(71) Applicant: STMicroelectronics International N.V., 1118 BH Amsterdam (NL)
(72) Inventor: Tassart, Stéphan, 75019 Paris (FR)
(74) Representative: Casalonga

(57) **Abstract**

A method and an apparatus (100, 110, 150, 160, 700) for loudness control at audio rendering of an audio signal. The apparatus (100, 110, 150, 160, 700) obtains (201) information informing about different circumstances associated with a present context of the audio rendering. Further, the apparatus (110, 150, 160) determines (204), based on the obtained information, one or more parameters associated with the present context. The apparatus (100, 110, 150, 160, 700) then provides (205) the determined one or more parameters to an audio rendering circuitry (140) configured to control loudness of the audio rendering of the audio signal based on the one or more parameters. Automatic or semi-automatic adaptation of loudness at audio rendering of the audio signal is enabled as well as implementation in many existing type of devices, such as smart phones.

## Description

### TECHNICAL FIELD

Embodiments herein relate to a method and an apparatus for loudness control at audio rendering of an audio signal.

### BACKGROUND

The loudness of a sound is the psychoacoustic quality that correlates to its physical strength. Being louder than its competitors has been and still is a marketing target for many content providers and broadcasters. This loudness race is observed in TV advertising broadcast, in Frequency Modulation (FM) radio broadcast and in music mastering. Since the loudness is related to the amplitude of the sound, an obvious mean for increasing the loudness is increasing the amplification. For a given medium, the range of amplification is limited if the transformation meant of the sound is to be linear, i.e. without audible distortion. It is important to note that, for years, amplifying the audio signal was the principal mean for increasing the loudness. This explains that loudness was initially estimated by measurements mainly related to the amplitude of the signal, such as Volume Unit (VU) meters, crest-to-crest amplitude, etc., in many broadcasting standards. Compressing the dynamic range of the signal is another method. The principles of the dynamic compression are rather simple. In order to keep the loudness artificially high, the volume of the sound is raised when the loudness is low. This process is known as Dynamic Range Compression (DRC). When this process is automatized in an electronic device, the resulting audio is said to be compressed. There are many cases that require DRC processing. In some cases, for objective and physical reasons, the "natural" dynamic range of a medium is closely related to the range of amplitude levels that keeps the modification of the signal linear. Say for instance that the dynamic range of a medium is, for a given wideband sound, the amplitude ratio in decibel (dB) between the lowest possible level, when the sound is still perceptible above the noise floor, and the highest possible level, when the sound is amplified without audible distortion. For instance, the dynamic range is about 50 dB for analogue audio tapes, 60 dB for long-play analogue discs, 70 dB for FM radio, 96 dB for audio Compact Discs (CDs) etc.

Dynamic range may also be defined for different environments where the audio content is to be rendered, with the highest possible level to be understood in the given context. For instance, the dynamic range for a concert hall is normally more than 100 dB, but typically significantly less for a jazz-club because of the noise of the audience chatting at the bar. The available dynamic range of a specific location may thus vary depending on the context. As a further example, the available dynamic range from the living room of an urban apartment varies from 30 dB, such as at 6 pm when children are awake and yelling, to 50 dB, such as when the children sleeps at 9 pm and it is quiet for the evening movie. It may then get back to 30 dB during late night when everyone are sleeping and loudness is very limited.

The dynamic range may also be defined for audio contents, as the audio level between the quietest moment of the content and the loudest moment of the content.

Additionally, the human ear is submitted to dynamic range limitations. The dynamic range of the human ear, i.e. the range between the perception threshold and the pain threshold, is not equal for all frequencies. The dynamic range of a human ear is at the highest between 1 to 3 kHz and it is also modulated by the so called equal-loudness contours that represent the level of a pure sound with an equal-loudness rating at different frequencies.

Quite naturally, the main problem in audio broadcasting and recording is to adapt the dynamic range of the content to the available dynamic range, i.e. the worst dynamic range between the transportation medium, the storage medium or the human ear in its listening environment. Initially, audio compression was developed to be used with dynamic range adaptation. For instance, Dolby-B® is a compression and decompression, i.e. expansion, scheme developed in order to adapt the dynamic range of musical content to the limited dynamic range of analogue audio tapes.

The often called "loudness" button on High Fidelity (HiFi) sound equipment is another application of dynamic range compression. Consider for instance an audio content with a dynamic range of 50 dB, varying mostly between 40 dB and 90 dB Sound Pressure Level (SPL). The rendering of this audio content on the HiFi equipment may be commanded 20 dB lower, i.e. with the quietest moment of the audio content rendered at 20 dB SPL which is well below the noise floor in an urban apartment. As a result, the rendering of the audio will not be "optimal" since parts of the content cannot be heard. A solution available in many HiFi equipment to this problem is said "loudness" button, which when pressed compresses the content so that e.g. the lowest moments are still rendered at 40 dB SPL, while the loudest moments are rendered at 90-20 = 70 dB SPL.

In some cases, the audio broadcaster adapts the compression rate to the expected rendering environment. For example, audio is compressed differently for TV shows, TV news, cinema movies etc. Nowadays, dynamic range limitations are mainly decided by the environment and the context where the audio is to be rendered. As a consequence, applying audio compression at the rendering stage, depending on the context, is suitable. This is also the architectural choice for audio encoding on DVD media, e.g. DVD movies. Audio can be encoded uncompressed on the DVD and compression be applied at the decoding stage, where the user may choose the compression rate depending on the environment, e.g. by choosing "home theatre", "quiet TV", etc.

The compression rate may also be the result and/or be affected by standardization constraints.

From the above it may be understood that compression may, as a side effect, increase the loudness without increasing the maximum VU-meter indication. This is e.g. utilized for TV commercial advertisement where audio may be highly compressed in order to be louder while not infringing the maximum VU-meter indications from the broadcasting standards.

This loudness "war" with highly compressed audio content is also present on FM radio broadcasts where radio channels want to sound louder than their competitors even when radio listening equipment are tuned to the same amplification level. As a consequence, some radio channels broadcast their music content highly compressed, which has become some sort of popular musical aestheticism. Audio producers tend to produce recorded popular music more and more compressed. Even subsequent releases of the same audio content may involve more and more compression nowadays.

One interesting side-effect from the high level of compression in music is that music listening become possible in many noisy environments that often is the case for e.g. portable audio listening devices, including smart phones etc. Indeed, only highly compressed music may be listened to in a public transportation environment where the available dynamic range may be less than 10 dB.

It may further be noted that the general audio listener is typically not well educated about audio dynamic range control concepts whereas, in imaging and video, those concepts are often better understood and are even given specific words, namely brightness and contrast. It is a fact that most imaging and video devices have separate brightness and contrast controls whereas audio devices normally only have an amplitude control, which corresponds to brightness, but no compression rate control, which corresponds to contrast. It is also a fact that there does not even exist an English word for "audio contrast". Therefore, even if dynamic range controls on audio devices could be a neat solution to e.g. the above described loudness "war", it is small chance that such controls would be suitable to directly expose to the non-educated public. However, dynamic range controls are available on professional and semi-professional audio equipment.

For the time being, most solutions up to date, except for said case of audio tracks on DVD movies, require that the creator, or the broadcaster, of the audio content chooses the type of environment and context where the audio content is expected to be rendered and applies a compression rate accordingly. In fact, audio on DVDs is more or less the only example where audio is not specifically compressed for a specific environment. Depending on the model of DVD players, this control is typically available to the user in an "on/off" mode, in a "mid-night movie" mode, or using a scale varying from 0 (off) to 8 (full). Usually, the control is only available in "expert" menus and therefore not practical to use.

Some car audio equipment offers an automatic car audio loudness setting that depends on the car cockpit environmental noise that may be estimated from the car speed or measured from microphones. Some few advanced car equipments exploit the spectrum of the car cockpit environmental noise in order to improve the loudness with a variable audio equalization. However, those solutions are limited to car audio in the cockpit.

Mobile equipment, e.g. wireless devices such as smart phones etc, usually do not offer any solution for controlling the rate of compression applied to the audio. As a result, listening to non-compressed music in a very noisy environment, such as public transportations, car cockpits, street etc., is either not possible or requires a very high volume that is possibly damaging to the ears.

### SUMMARY

In view of the above, an object of embodiments herein is to provide improved handling of loudness control at audio rendering.

According to a first aspect of embodiments herein, the object is achieved by a method in an apparatus for loudness control at audio rendering of an audio signal. The apparatus obtains information informing about different circumstances associated with a present context of the audio rendering. The apparatus determines, based on the obtained information, one or more parameters associated with the present context. Moreover, the apparatus provides the determined one or more parameters to an audio rendering circuitry configured to control loudness of the audio rendering of the audio signal based on the one or more parameters.

According to a second aspect of embodiments herein, the object is achieved by an apparatus for loudness control at audio rendering of an audio signal. The apparatus comprises an obtaining circuitry configured to obtain information informing about different circumstances associated with a present context of the audio rendering. The apparatus further comprise a determining circuitry configured to, based on the obtained information, determine one or more parameters associated with the present context. Moreover, the apparatus comprises a providing circuitry configured to provide the determined one or more parameters to an audio rendering circuitry, which audio rendering circuitry is configured to control loudness of the audio rendering of the audio signal based on the one or more parameters.

By obtaining and utilizing, as described above, information informing about the different circumstances associated with the present context of the audio rendering, the method and apparatus enable loudness to be automatically or semi-automatically adapted to the present context, at the audio rendering of the audio signal. The method and/or apparatus also enable implementation in many existing type of devices, such as smart phones.

### BRIEF DESCRIPTION OF THE DRAWINGS

Examples of embodiments herein are described in more detail with reference to attached drawings in which:
Figure 1 is a schematic block diagram depicting a non-limiting example of a device for contextual adaptive loudness control, in which embodiments herein may be implemented.
Figure 2 is a flow chart illustrating a method in an apparatus according to embodiments herein.
Figure 3 is a schematic block diagram depicting an architecture for a multimodal context analysis that may be used with embodiments herein.
Figures 4-6 are a schematic block diagrams depicting examples of Dynamic Range Controllers (DRC) that may be used with embodiments herein.
Figure 7 is a schematic block diagram illustrating an apparatus according to embodiments herein.

### DETAILED DESCRIPTION

Embodiments herein will be exemplified in the following detailed non-limiting description. However, before presenting embodiments herein and as part of the development towards embodiments herein, the situation and problem indicated in the Background will be further discussed.

Exposing explicitly audio dynamic range controls to a typically non-professional user would be a solution to the aforementioned "loudness war" and related problems mentioned above in the Background, but there are little chances that such controls would be accepted by users or be commercially viable. An automatic or semi-automatic solution would be more suitable. Such solution should be able to adapt to different contexts. Audio compression is typically applied statically at many locations in the audio chain from production to broadcast but it may actually only be needed at the audio rendering stage on contextual basis.

Many audio rendering equipment of today, such as multi-purpose user devices including e.g. smart phones, tablets etc, are equipped with multi-modal sensors including e.g. inertial sensors, ambient light detectors, GPS circuits etc. Application Programming Interfaces (API) associated with the Operating Systems (OSes) associated with such devices normally provide simple access to information from such sensors and also further information, such as wireless information e.g. presence and/or identity of close-by other Bluetooth (BT) enabled devices, Wi-Fi or Global System for Mobile Communication (GSM) base stations etc. Wi-Fi refers to wireless communication according to the IEEE 802.11 standard. Also less complex devices with audio rendering capabilities are often at least equipped with microphones, e.g. uplink microphones in telecommunication enabled devices such as mobile phones, dictaphone microphones in many MP3 players, reference microphones in Active Noise Control (ANC) enabled headphones, reference microphones in Adaptive Noise Cancelling (also ANC) enabled mobile phones etc. This large set of multi-modal sensors and information that often are available and accessible in devices may be used and analyzed to be able to automatically or semi-automatically detect audio rendering context and/or adapt to the audio rendering accordingly.

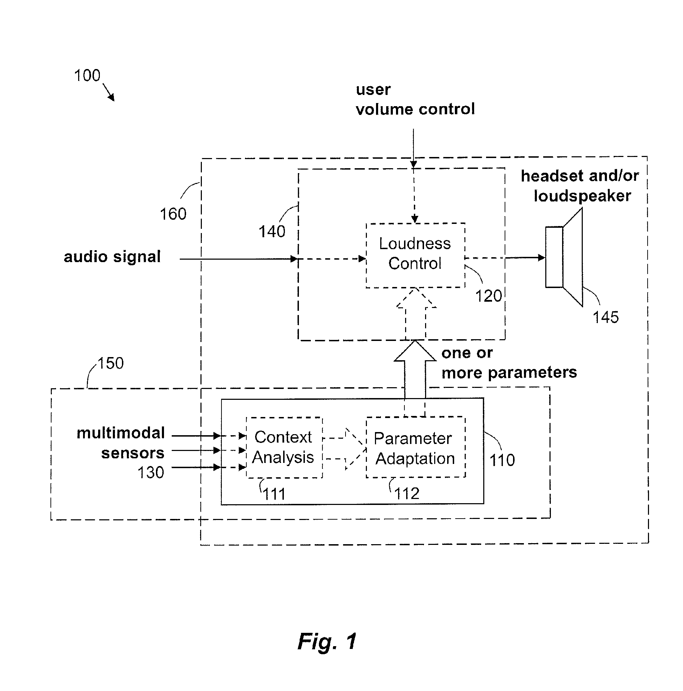

**Figure 1** is a schematic block diagram depicting a non-limiting example of **a device 100,** which herein also may be referred to as an apparatus 100, for contextual adaptive loudness control, in which embodiments herein may be implemented and in relation to which embodiments herein will be explained. The shown parts of the device may be physically integrated in one and the same unit, but in some embodiments some parts may be physically separated, as will be explained below.

The device 100 may fully or partly be comprised in a communication device such as a wireless device that also may be known as e.g. user equipment, mobile terminal, wireless terminal and/or mobile station. A wireless device is enabled to communicate wirelessly in a cellular communications network, wireless communications system, or radio communications system, sometimes also referred to as a cellular radio system or cellular network. The communication may be performed e.g. between two wireless devices, between a wireless device and a regular telephone and/or between a wireless device and a server via a Radio Access Network (RAN) and possibly one or more core networks, comprised within the cellular communications network. Moreover, the device 100 may fully or partly comprised in what may be referred to as a mobile telephone, cellular telephone, smart phone, laptop, Personal Digital Assistant (PDA), tablet computer, just to mention some further examples. The device 100 may thus fully or partly be, for example, portable, pocket-storable, hand-held and/or computer-comprised.

The device 100 comprises **a first apparatus 110,** and **a parameter adaptation circuitry 112** that may be comprised in the first apparatus 110. The first apparatus 110 may, as indicated in the figure, also comprise **a context analysis circuitry 111.** Said circuitries and functions thereof, and the parameters, will be further described in, and better understood from, the below.

The first apparatus 110 may be in the form of a separate physical or logical circuitry or component that e.g. may be comprised in any of the above-mentioned devices, such as an ANC enabled headphone.

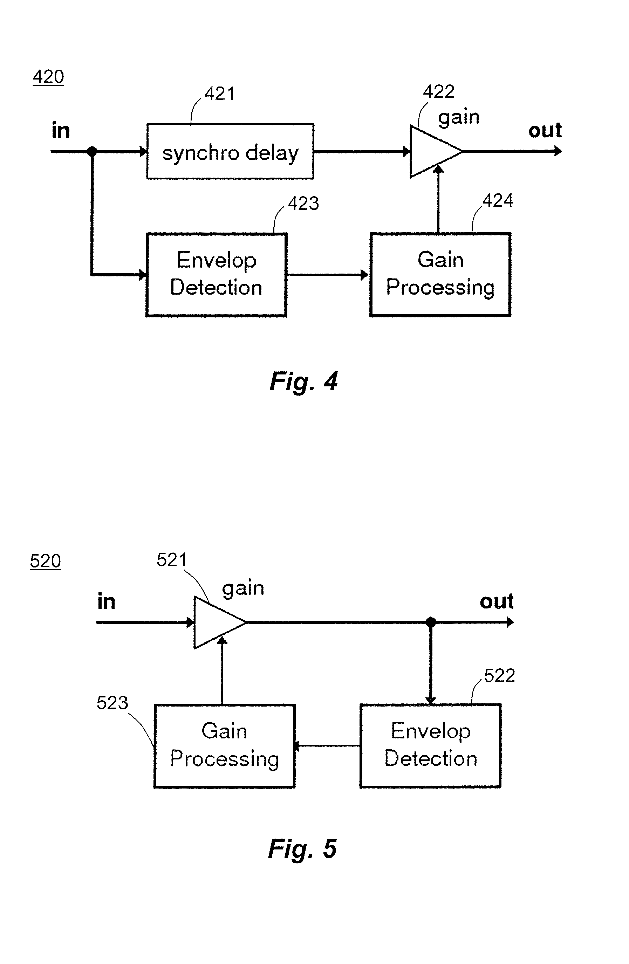

The shown device 100 further comprises **a loudness control 120,** typically corresponding to a compression scheme or algorithm, e.g. for dynamic range compression, that may be implemented in various ways. Preferably the loudness control 120 comprises a Dynamic Range Controller (DRC) that will be further discussed and exemplified below. Example architectures for implementation of the loudness control 120 by means of DRCs are shown in Figures 4-6. Also other kind of loudness control is possible to use with embodiments herein as realized by the skilled person, such as static gain modification in the digital domain or the analog domain or loudness control by distortion. The loudness control operates on an audio signal and controls loudness thereof at audio rendering. The loudness control 120 is typically part of an audio rendering circuitry, such as **an audio rendering circuitry 140** indicated in the figure. **A headset or loudspeaker 145** may also be considered part of the audio rendering circuitry, although it is more common to refer to the audio rendering circuitry 140 separate therefrom but arranged to feed said headset or loudspeaker 145 with an audio signal for playback by the headset or loudspeaker, which audio signal has been adapted, here including adaptation by said loudness control 120. The final step of audio rendering, i.e. playing out the adapted audio signal is carried out by the headset or loudspeaker 145. The shown loudness control 120 and audio rendering circuitry 140 are shown with an input for receiving the one or more parameters from the first apparatus 110, or in the example more specifically from the parameter adaptation circuitry 112.

The device 100 is also shown to comprise **multimodal sensors 130** that may comprise the type of sensors that have already been discussed, and will also be further described and exemplified below. In some embodiments, all or some of the multimodal sensors 130 are comprised in the same apparatus as the context analysis block 111 and the parameter adaptation block 112, which is illustrated by **a second apparatus 150** indicated in the figure. In some embodiments there is an apparatus, illustrated by **a third apparatus 160** in the figure, that comprises the context analysis block 111, the parameter adaptation block 112 and the audio rendering circuitry 140. As already mentioned, in some embodiments there is an apparatus or device, e.g. in the form of a smart phone, that comprises the whole device 100, but with the headphones, when such are involved in the audio rendering, typically excluded. When headphones are connected audio rendering is typically carried out through these instead of the loudspeaker, e.g. an internal loudspeaker of the smartphone.

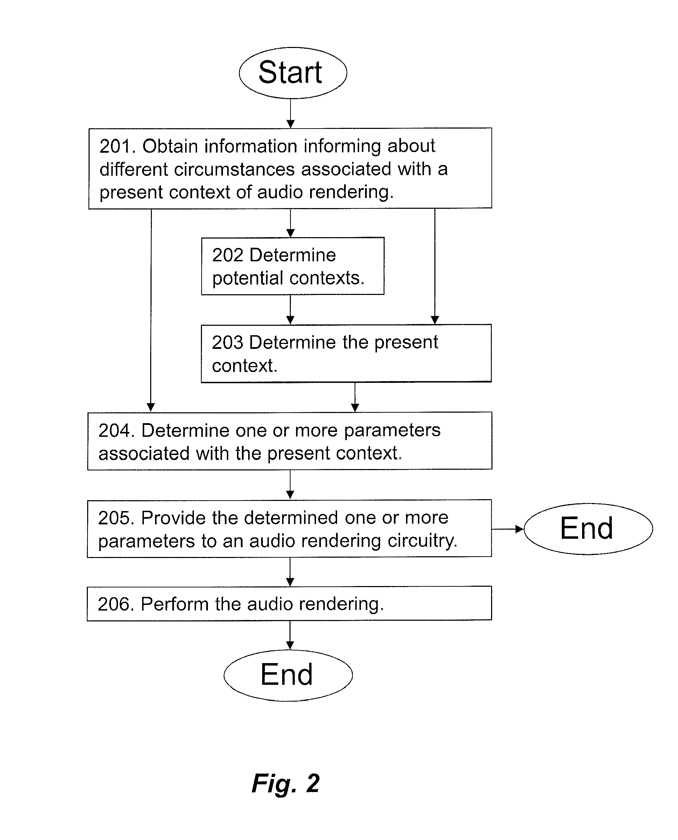

**Figure 2** depicts a flowchart that in the following will be used to elaborate and describe embodiments herein relating to a method in an apparatus for loudness control at audio rendering of an audio signal. The apparatus may e.g. correspond to the first apparatus 110, the second apparatus 150, the third apparatus 160, or an apparatus comprising or corresponding to the device 100. In some embodiments the audio rendering comprises to control a dynamic range of the audio signal of the audio signal based on the one or more parameters, for example by means of a dynamic range controller comprised in the audio rendering circuitry 140 and that is configured to control the loudness of the audio rendering. The method comprises the following actions, which actions may be taken in any suitable order. Further, actions may be combined. Note that the apparatus for the loudness control may, but not need to, be configured to also carry out the audio rendering.

### Action 201

The apparatus 100, 110, 150, 160 obtains information that informs about different circumstances associated with a present context of the audio rendering. The obtained information may originate from sources of different type, which increase and in practice often may be necessary to be able to determine the one or more parameters discussed below with a desirable accuracy. Multiple sources of different type also increase robustness in case one source for some reason is malfunctioning or cannot provide adequate input, e.g. in case of a microphone source muffled by a pocket. The multimodal sensors 130 are examples of the sources that also will be further exemplified and discussed below. The obtained information may comprise raw data and/or pre-processed data originating from the sources. The sources may comprise one or more sensors configured to sense at a location of the audio rendering and provide at least part of the raw data and/or pre-processed data.

Circumstances associated with a present context of the audio rendering e.g. comprise circumstances at the physical location of the audio rendering when the audio rendering is taking place. The circumstances are typically such that provide clues about factors in the environment of the audio environment, which factors are relevant for loudness adaptation. The different circumstances that the information informs about may relate to one or more of the following:
- Location associated with the audio rendering.
- Activity, e.g. an activity state and/or degree and/or level and/or type, of a device configured to carry out the audio rendering, e.g. the third apparatus 160, the device 100 or a separate device comprising the audio rendering circuitry 140. Hence, note that said device configured to carry out the audio rendering may comprise the apparatus 110 but not necessarily, e.g. in case the audio rendering circuitry 140 is comprised in a separate headphone device and the apparatus 110 is comprised in another device, e.g. tablet computer, that controls the headphone device but is located at a distance.
- Time and/or date associated with the audio rendering.
- Interaction, e.g. interaction state and/or degree and/or level and/or type, between said device configured to carry out the audio rendering and a user of said device. The interaction may be physical and/or by use of the device.
- Motion and/or orientation, e.g. motion and/or orientation state and/or degree and/or level and/or type, of said device configured to carry out the audio rendering,
- Ambient sound, e.g. degree and/or level and/or type thereof, at the location associated with the audio rendering.
- Ambient light, e.g. degree and/or level and/or type thereof, at the location associated with the audio rendering.
- Ambient temperature at the location associated with the audio rendering.
- Air pressure, e.g. level thereof, at the location associated with the audio rendering.
- Humidity, e.g. degree or level thereof, at the location associated with the audio rendering.
- Communication, e.g. an activity state and/or degree and/or level and/or type, to and/or from the apparatus 110 and/or said device configured to carry out the audio rendering.

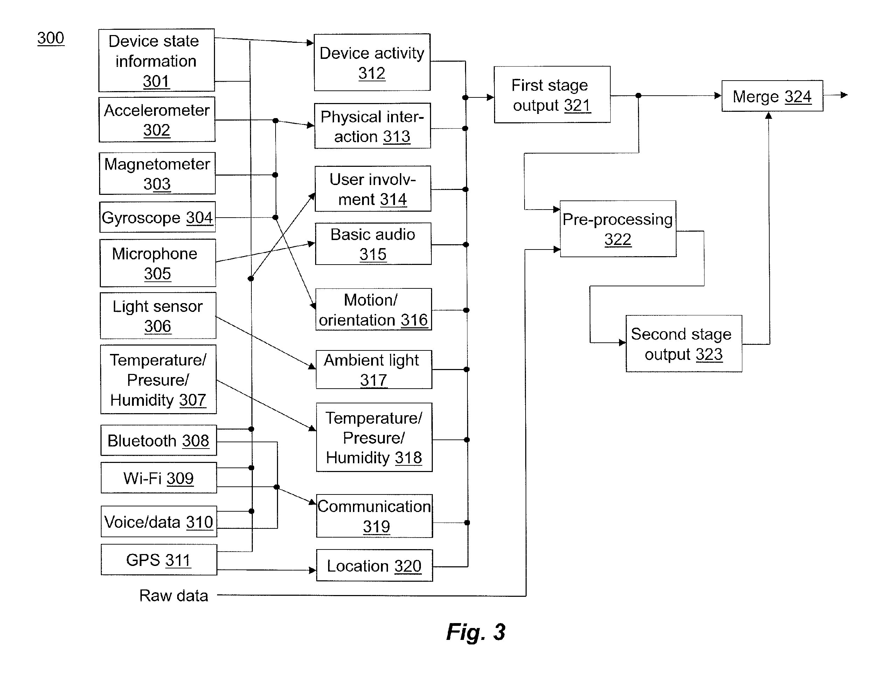

The information, the raw data the pre-processed information and examples thereof will be further discussed below in connection with Figure 3.

When the apparatus, e.g. the first apparatus 110 or second apparatus 150, configured to carry out the method is separate from one or more of the sources, e.g. the multimodal sensors 130, the information may at least partly be obtained by being received from said one or more sources. For sources comprised in the apparatus configured to carry out the method, e.g. in case of the multimodal sensors 140 comprised in the third apparatus 110, the information may be obtained internally in the apparatus, e.g via storage in common memory.

In some embodiments the determination of the one or more parameters is based on fusion of data comprised in the obtained information originating from the sources. By fusion of data is herein generally meant combination of data. The fusion of data is either:
1) Early fusion where the data, e.g. raw data, is combined before any classification, i.e. the combination is not involving any determined context. Early fusion data may be applied as a concatenation of the data.
2) Late fusion where the data comprise both data before classification and data resulting from of the use of classification, i.e. resulting from one or more determined contexts. The latter may be but is not limited to, decisions and/or opinions on potential, i.e. most likely, contexts.

The fusion and variations thereof will be further discussed below in relation to Figure 3.

### Action 202

In this action, which is optional for embodiments herein, the obtained information comprises a first subset of the information and the apparatus 100, 110, 150, 160 determines potential contexts based on the first subset. The potential contexts may be viewed upon as a subset of all contexts that initially are possible, and thus correspond to a more limited amount of contexts comprising the present context. The potential contexts may be explicitly or implicitly determined. An example of implicitly determined context is e.g. determination of sudden loss of a GPS signal and/or change in ambient light, and use this information as if it has been determined that the context is indoor although it is not explicitly concluded or determined "thus the context is indoor". The potential context and use thereof are further discussed below.

### Action 203

In this action, which is optional for embodiments herein, the apparatus 100, 110, 150, 160 determines the present context based on the obtained information. The present context may be explicitly or implicitly determined.

In embodiments where the potential contexts are determined based on the first subset according to action 202, the present context is determined based on the determined potential contexts. As will be explained further below, obtaining and/or process a subset of the information separately, e.g. before a remainder of the information, may be advantageous or even needed in some situations, e.g. in order to practically accomplish an "always on" service when the apparatus is battery powered.

In some embodiments, the obtained information comprises a second subset of the information and the apparatus determines the present context and/or the potential contexts in response to that the second subset of the information informs about one or more circumstances indicating a change of the present context. The change may be potential, e.g. likely, or actual. As also will be discussed below in connection with Figure 3, a remainder of the information may be obtained and/or processed only when the second subset informs about such circumstances, e.g. a change in ambient sound level that is over a certain threshold level and/or that the device carrying out the audio rendering has changed from being located indoor to outdoor etc. Hence, effort will be spent on determining potential contexts and/or the present context only when there first is indication of at least a potential change of present context and thus that such determination is relevant. This may be used to save power and make sure that resources are spent on determination as in action 203, 204 etc. only when this is meaningful.

In some embodiments, the apparatus obtains the first subset and/or the second subset according to action 202 and/or action 203 from one or more of the sources, e.g. a microphone comprised in the multimodal sensors 130, operated with a power consumption that is lower than when one or more of the sources, e.g. all or multiple of the multimodal sensors 130, are operated to provide a remainder of the obtained information.

In some embodiments, the first subset and/or the second subset of the information are processed by the apparatus 100, 110, 150, 160 for the determination of the present context and/or the potential context based on a first algorithm that requires less power consumption than a second algorithm for processing a remainder of the obtained information for the determination of the present context.

The above described kind of a "low power" mode may in some situations, e.g. in case the apparatus 100, 110, 150, 160 is battery powered, be advantageous, or even needed in case of an "always on" service. That is, in such case, the apparatus may first obtain and/or process a subset of the information at a lower power mode and then obtain and/or process the remainder at a higher power mode e.g. in response to that the obtained subset, similar as described above, indicates that continuing is relevant and makes sense. The first algorithm may thus be used in the lower power mode and the second algorithm in the higher power mode. This will be further discussed below in connection with Figure 3.

Note that the naming "first" and "second" regarding the subsets is just for indicating that the subsets need not be the same and typically comprise different information. However, there may be cases where the first and the second subset partly or fully comprise the same information but the information may be used and/or processed differently. Moreover, the first and/or second subset of information and/or the remainder of the obtained information may be obtained partly or fully overlapping in time or sequentially, where e.g. the first and/or the second subset may be obtained first and then the remainder of the obtained information.

### Action 204

The apparatus 100, 110, 150, 160 determines one or more parameters associated with the present context based on the obtained information.

When the present context is determined based on the obtained information according to action 203, the one or more parameters are determined based on the determined present context. Determination of the present context may e.g. be performed by the context analysis block 111 and will also be further discussed below in connection with Figure 3. According to action 201 the obtained information informs at least about circumstances associated with the present context, and the one or more parameters may in some embodiments be determined directly from the different circumstances that the obtained information informs about, e.g. ambient sound level at and location of the audio rendering, which may be used to determine the one or more parameters so that the loudness adaptation at least may be better performed than else would be the case. The present context is typically independent on the apparatus carrying out the method, e.g. a smart phone. However, in contrast, how to determine the present context is typically dependent on the apparatus and its capabilities, e.g. which multimodal sensors are available etc. From an implementation point of view it may therefore be advantageous to, as in the present action, first determine the present context and then determine the one or more parameters based on the determined present context.

### Action 205

The apparatus 100, 110, 150, 160 provides the determined one or more parameters to an audio rendering circuitry, e.g. the audio rendering circuitry 140, configured to control loudness of the audio rendering based on the one or more parameters.

Hence, and in view of the previous actions, the method enables loudness to be automatically or semi-automatically adapted to the present context, at the audio rendering of the audio signal. The method also enables implementation in many existing type of devices, such as smart phones.

When the apparatus, e.g. the first apparatus 110 or second apparatus 150, is separate from the audio rendering circuitry, e.g. the audio rendering circuitry 140, the one or more parameters are provided by being sent to the audio rendering circuitry. The sending may be wireless or by wire. When the audio rendering circuitry, e.g. the audio rendering circuitry 140, is integrated with the apparatus, e.g. the apparatus 160, the one or more parameters may e.g. be provided via storage in common memory.

The one or more parameters, e.g. output from the parameter adaptation circuitry 112, are such suitable for the type of audio rendering circuitry 140 being used, e.g. depending on what parameters are used by the loudness control 120 comprised therein. The one or more parameters are typically represented by a value or set of values that may be discrete or continuous. Examples of parameter values that are discrete are binary values, such as a value for on/off switching, a list of presets or profiles corresponding to individual contexts such as street, car, train, office, quiet. Examples of parameters values that are continuous are a values that changes with ambient sound, e.g. noise, that is continuously sensed and the obtained information is based on, and values that changes with modulating parameters associated with compression of the audio being rendered, e.g. compression rate, a vector of gain thresholds, etc.

When the apparatus, e.g. the first apparatus 110 or second apparatus 150, configured to carry out the method is separate from one or more of the sources, e.g. the multimodal sensors 130, the information may at least partly be obtained by being received from said one or more sources. For sources comprised in the apparatus configured to carry out the method, e.g. in case of the multimodal sensors 140 comprised in the third apparatus 150, the information may be obtained internally in the apparatus, e.g. via storage in common memory.

### Action 206

In this action, which is optional for embodiments herein, the audio rendering is performed based on the provided one or more parameters and the audio signal. That is, in case of this action the method would be carried out by an apparatus also involved in carrying out the audio rendering, e.g. the third apparatus 160.

In some embodiments, the audio rendering is additionally performed based on a received signal for controlling audio volume, e.g. as exemplified in Figure 1 by the user volume control input.

In some embodiments, the information is obtained according to action 201, and/or the one or more parameters are determined according to action 204, in response to the received signal for controlling audio volume. This is advantageous since only a conventional volume control thereby may be exposed to the user and activation of loudness adaptation according to embodiments herein may thus occur in response to conventional user interaction. Automatic change of loudness without being triggered by user interaction may be annoying to the user, at least it may be desirable to be able to provide a mode that is not fully automatic and always on, and not determined purely by the present context of the audio rendering. It is of course also possible to activate the loudness adaptation according to embodiments herein by a separate user accessible button or setting.

The method and embodiments described above enable automatic or semi-automatic determination of one or more parameters that may adapt and even optimize loudness at audio rendering of the audio signal. The parameters may e.g. be provided to a DRC, as exemplified in Figures 4-6 and discussed below. As a result, the loudness at the audio rendering may be adapted automatically or semi-automatically to e.g. noisy public transportation environment, noisy street environment, quiet office environment, car environment, late home environment etc. The loudness parameters may be determined on-line and in real-time automatically and/or based on user input, such as via a conventional volume control, and multi-modal context analysis. An example implementation of the context analysis with scene detection service is in Figure 3 and will be discussed next for better understanding of embodiments herein.

**Figure 3** is a schematic block diagram depicting, as example, **an architecture 300** for a multimodal context analysis that may be used for implementing embodiments herein, e.g. embodiments relating to Action 201-203 discussed above. The architecture 300 may e.g. fully or partly be comprised in or correspond to the context analysis circuitry 111 in Figure 1 and thus e.g. be comprised in the first, second or third apparatus 110, 150, 160 or device 100 discussed above.

The architecture 300 comprises different **information sources 301-311,** which represent different modalities and may be referred to as modalities herein. The information sources 301-311 are examples of the above-mentioned sources of different type. Each information source provides output data being raw data and/or data that to some extent first have been pre-processed by the source. The data provided by respective source is typically what is available via an API for accessing the respective source, which API typically is provided by a producer of a device that implements the architecture. Such device may be a smart phone that also may be recognize as a device that in practice often comprise information sources of the types as in the figure. The information sources 301-311 shown as examples comprise: **a device state information source 301, an accelerometer 302, a magnetometer 303, a gyroscope 304, a microphone 305, a light sensor 306, a temperature and/or pressure and/or humidity sensor/s 307, a Bluetooth circuitry 308, a WiFi circuitry 309, a voice and/or data traffic monitoring circuitry 310** and **a GPS circuitry 311**. Note that data traffic is meant to include also special kind of data traffic such as Short Message Service (SMS) traffic. Said mentioned information sources 301-311 are merely examples and it should be understood that additional information sources are also possible, and that implementations of embodiments herein may involve both less and more information sources than mentioned herein. One example of an additional information source is a proximity sensor, e.g. sonic or ultrasonic based, light based, etc. By proximity sensor is meant a sensor that provide information informing about e.g. distance to an object close to the sensor. Some of the above-mentioned information sources 301-311 are recognized as corresponding to the one or more of multimodal sensors 130 discussed in the foregoing, while other, such as the device state information source 301 and Wi-Fi circuitry 309 are other kind of sources but that still may provide information that informs about circumstances associated with the present context of the audio rendering. For example, the Wi-Fi circuitry 309 may provide information about the location, e.g. if located at home or at some other location associated with particular circumstances, and the smart phone state information may provide information about e.g. current time, flight mode, and/or if sensors that are activated or not, applications being used etc.

Also note that there may be multiple instances of the same kind of information source, for example the microphone 305 may include one or more different microphones, e.g. in case of a smart phone, one microphone inside a headset connected thereto, which may provide a reference noise signal, another microphone for dictaphone purposes integrated in the smart phone and/or yet another microphone for ordinary voice communication integrated in the smart phone. How one or more microphones may be used in the context of embodiments herein is further discussed separately below. Comparison of power in certain spectral bands from two different microphones may provide clues on a current usage of the system, e.g. may this help to detect that the main device is in the pocket of the user. In other cases, the set of microphones may on the information source level be used together for instance for beam forming or for adaptive noise cancellation, but providing only one resulting audio channel. This kind of operation may be hidden by an API for example so that applications do not have access to the separate microphone data e.g. from an microphone array, only said resulting audio channel. When output data from the information sources 301-311, e.g. from said one resulting audio channel from the microphone 305, is used, e.g. via the API, any processing that have taken part on the information source level to produce the output data may be hidden.

All or some of the information sources 301-311 may provide output data to different **first stage processing blocks 312-320** that are configured to at least interpret and/or adapt the received output data, and in some cases also utilize output data from a plurality of the sources 301-311, to generate and provide respective information informing about one or more specific circumstances. The information provided by respective first stage processing circuitry 312-320 is provided to **a first stage output block 321** that will be explained below.

For example, the figure shows **a user involvement recognizing block 314** that receives output data from the device state information source 301, the Bluetooth circuitry 308, the WiFi circuitry 309, the voice and/or data traffic monitoring circuitry 310 and the GPS circuitry 611. The user involvement recognizing circuitry 314 is configured to operate on this received data to generate and provide information recognizing circumstances relating to user involvement, which may correspond to the above-mentioned circumstance relating to interaction by use of the device configured to carry out the audio rendering. The first stage processing circuitries 312-320 shown as examples additionally comprise:
**a device activity recognition block 312** that e.g. is configured to operate on the output from the device state information source 301 to provide information informing about circumstances relating to activity on the smart phone,
**a physical interaction block 313** that e.g. is configured to operate on the outputs from the accelerometer 302, the magnetometer 303 and the gyroscope 304 to provide information informing about circumstances relating to physical interaction between the device configured to carry out the audio rendering and the user thereof, such as mentioned above,
**a basic audio information block 315** that e.g. is configured to operate on the output from the microphone source 305 to provide information informing about circumstances relating to ambient sound, such as mentioned above,
**a motion and/or orientation block 316** that e.g. is configured to operate on the outputs from the accelerometer 302, the magnetometer 303 and the gyroscope 304 to provide information informing about circumstances relating to motion and/or orientation, such as mentioned above,
**an ambient light block 317** that e.g. is configured to operate on the output from the light sensor 305 to provide information informing about circumstances relating to ambient light as mentioned above,
**a temperature and/or pressure and/or humidity block 318** that e.g. is configured to operate on outputs from the temperature and/or pressure and/or humidity sensor/s 307 to provide information informing about circumstances relating to ambient temperature and/or air pressure and/or humidity, such as mentioned above,
**a communication block 319** that e.g. is configured to operate on the outputs from the Bluetooth circuitry 308, the Wi-Fi circuitry 309 and the voice and/or data traffic monitoring circuitry 310 to provide information informing about circumstances relating to communication, such as mentioned above, i.e. here to and/or from the smart phone, and
**a location block 320** that e.g. is configured to operate on the GPS circuitry 311 to provide information informing about circumstances relating to the location as mentioned above, e.g. whether the location is an indoor or outdoor location.

The architecture 300 is an example of a processing architecture for context analysis. As understood from the above, the architecture 300 involves different optional processing blocks and may provide a context detection service. The context detection service may operate in the background of a device on which the service is running, e.g. smart phone. Such service may operate in an operation mode referred to as "always on". In order to save battery time of the device, the building blocks exemplified in Figure 3 may be independently switched on/off in such a way that different power modes are possible, e.g. as discussed above. For instance, the aforementioned low power mode may involve only the microphone source 305, preferably set to sampling ambient sound at a low sampling frequency e.g. below 8 kHz, such as in the range of 4-8 kHz, but typically not so low that human voice, which mainly is in the frequency band 1-3 kHz, is not captured. The sampled sound may then be provided as raw data to the basic audio information block 315 that may operate on and process the sampled sound by e.g. by simply calculating the long-term Root Mean Square (RMS) level and provide the result to the first stage output block 321. In this case the first stage output block 321 is configured to take a decision based on this level and to continue with deeper analysis at higher power in case the long term RMS level is sufficiently far from a threshold level. For this purpose the first stage output block 321 may simply operate as a threshold comparator. The threshold level may e.g. be predetermined or been set as a previously sampled long term RMS level. Simple processing and low amount of data e.g. enable use of an algorithm that can be simple and thus may be implemented to require low power. The first stage output block 321 may thus either confirm an idle condition of the device and stay in low power mode, or decide that deeper analysis is required and therefore enter a medium or higher power mode including e.g. to switch on one or more information sources 301-311 and/or processing blocks 312-320. One purpose of the first stage output circuitry 321 is thus to allow for transitions from different operating power modes of the context detection service, typically a necessary condition for an "always on" service as discussed above.

A purpose of the context detection service is to use and/or merge obtained information originating from different sources and conclude therefrom what may be the present context of the audio rendering. The information may be used to provide several discrete or continuous clues about potential contexts and/or the present context. The processing paths shown in Figure 3 are optional and may be considered to illustrate two data fusion strategies, called early and late data fusion. Either one or both of these strategies may be implemented and used with embodiments herein.

The early fusion strategy comprises merging of data, such as raw data, direct from the different sources 301-311, illustrated by the "all raw data" line at the bottom of the figure, as early as possible and e.g. form a vector comprising output data from several different sources. For example, the vector comprising e.g. microphone recorded data, inertial data etc., may be provided to and/or formed by a front-end (FE) or **pre-processing block 322** as shown in Figure 3. The pre-processing block 322 may as shown have an additional input that is fed with output from the first stage output block 321 so that that the vector may contain information also from the first stage output block 321 and/or the first stage processing blocks 312-320. Hence the vector corresponds to a grouping of data with information informing about circumstances associated with the present context. In case of early fusion and data directly from the sources, the pre-processing block 322 may provide some adaptation and/or interpretation of the data from the sources. Early fusion comprises obtaining data originating from multiple sources and processing of the obtained data together. Or in other words, according to the early fusion strategy, information e.g. in the form of raw data from multiple sources of different types are obtained and used to determine or at least provide clues about the present context of the audio rendering. The pre-processing block 322 provides the result from the pre-processing as output data. The pre-processing block 322 may also be configured to only provide some of the input data as output data. The output is then fed to a back-end (BE) block that in the figure is named **a second stage output block 323.** What exact function the first stage output block 321 and the second stage output block 323 implement may differ in different embodiments but typically involve use of fusion data to classify, i.e. determine, the present context or potential contexts.

For example, in some embodiments in case of an implementation of the above-mentioned different power modes, the first stage output block 321 may as mentioned take decision based on input from the basic audio information block 315 to continue with deeper analysis at higher power. In response to the decision, the second stage output block 323 may via the pre-processing block 322 receive data from the information sources 301-311 and/or from the first stage processing blocks 312-320, and based on this determine the present context or potential contexts.

The late fusion strategy comprises some classification as early as possible in a first stage of processing on data streams, typically from one single source. Actual data fusion, or further data fusion, may then take place in a second stage processing, e.g. in a higher power mode, that involves a merge of different more high level indicators or clues and possibly also raw data.

For example, the scene detection service may in the first stage of processing discriminate indoor from outdoor environment with a certain amount of confidence by inspection and classification of GPS data, e.g. the availability vs. non-availability of GPS data involving the GPS block 311 and the location block 320. Motion and orientation may be obtained by early fusion of data originating from inertial sensors, such as accelerometer, magnetometer and gyroscope when available and to the extent needed. Some clues about the current social environment may also be provided by the user involvement recognizing block 314, e.g. by detection of Bluetooth identifiers in data originating from the Bluetooth source 308 and recognizing those as being from friends or family relatives. Such "early" clues extracted in the first stage of processing may then in a second stage of processing, involving e.g. the pre-processing block 322 and the second stage processing block 323, be merged with further information as discussed above. This way new and/or more confident, or robust, information may be obtained and used for determining the present context or at least potential contexts that represent reduction of all initially possible present contexts. If the first stage of processing results in a classification corresponding to a first number of potential contexts, the second stage may further narrow down the amount of potential contexts or even determine the potential context. If a number of possible present contexts are predefined or predetermined, and these are reduced to potential contexts and eventually only one remains, the remaining context is the present context. Even if potential contexts are output from the architecture 300 and not the present context, this is still useful for being able to better determine the one or more parameters associated with the present context.

In some embodiments implementing the above-mentioned different power modes, the first stage output circuitry 321 may as already mentioned take decision based on input from the basic audio information circuitry 315 and take a decision based on this to continue with deeper analysis at higher power. In response to the decision, the second stage output circuitry 323 may via the pre-processing circuitry 322 receive data from the information sources 301-311 and/or from the first stage processing blocks 312-320. Based on this the second stage output block 323 may determine the present context or potential contexts. In some embodiments, there may be a merge of resulting classification, or potential contexts, from the first and second stage of processing, as illustrated in Figure 3 by **a merging block 324.**

The context detection service that may be provided based on the example architecture 300 or similar may for example be used to robustly recognize the present context of the audio rendering being a sleeping room at night, and therefore that a user thereof is probably sleeping, by e.g. combining clues from classification of both audio and motion, said "indoor" clue from the location block 320, a home clue from the different wireless media, e.g. by detecting Wi-Fi or GSM spots identified as those close from home, a "being home" clue from a last outdoor GPS position and based on information on present local time that may be available from e.g. the GPS block 311 and/or the smart phone state information source 301.

The above kind of data fusion and use thereof involving information obtained from different sources of different type is considered an efficient way to increase the robustness of e.g. first, or primary, classification. For instance, in the context of mobile audio, the microphone source 305 may not be used efficiently alone to discriminate between noisy and quiet environments because, for instance, there are cases where recorded audio is muffled by a pocket or by a handbag. The described context detection service uses information from additional sources, or modalities, e.g. motion estimation, ambient light etc., which may nevertheless recognize e.g. a public transportation context and thereby be able to determine the one or more parameters so that loudness of the audio rendering is adapted to a noisy environment, even with a muffled audio signal.

It should be understood that, in a practical situation, exact details of what e.g. is possible and needed to implement for context analysis, is very use case dependent and dependent on what modalities are available. A very simple context analysis may comprise estimation of a long-term root-mean square (RMS) level of recorded audio from a microphone, a comparator utilizing hysteresis and two thresholds deciding whether the environmental noise is high enough in order to justify further detection of the different circumstances.

Note that RMS level is only an example of a measure that may be used. Other analysis of an audio signal that may be used are Zero Crossing Rate (ZCR), Mel-Frequency Cepstral Coefficients (MFCC), Spectral Centroid etc. Other measure on inertial data that may be used are e.g. mean, power, entropy, axis correlation, motion intensity, rotational direction etc. It is beneficial to produce measures that are invariant relatively to environmental perturbations that are irrelevant for the classification. For instance, MFCC and ZCR are considered good candidates for speech recognition tasks because those features are invariant to the actual signal scale since speech recognition not need to take care of the actual voice intensity in order to recognize words.

Implementations of the blocks 312-324 for classification, i.e. determination of the present context or potential contexts, are also very use case dependent and dependent on what modalities, e.g. sources 301-311, are available and what information they provide. For example, the threshold comparator mentioned earlier may be implemented as a simplified version of a classifier known as a Gaussian Mixture Model (GMM). The academic literature mentions many other practical classifiers: Hidden Markov Model (HMM), Support Vector Machines (SVM), artificial Neural Network (NN), k-Nearest Neighbours (k-NN) etc. These may be used in order detect basic type of environments such as public transportation, city street etc. from recorded ambient sound.

Implementation of a context analysis architecture such as the example architecture 300, may include pre-learning, or a learning phase, where the information sources, e.g. information sources 301-311, are used in different known contexts. For each known context a respective suitable set of one or more parameters for the loudness control may be determined, e.g. based on previous knowledge of what is suitable in such known contexts and/or by routine testing, Methods, such as described above, for determining present context based on data produced by the information sources may be verified against and/or adjusted based on the data that is produced for respective known context during the learning phase. It may even be possible to, based on pattern recognition among data obtained from the information sources for respective each known context, produce algorithms that subsequently may be used to identify same or similar patterns and thereby identify the present context

In case of implementation in another, e.g. new, apparatus for carrying out the method, e.g. a new hardware update of a smart phone, the set of the one or more parameters associated with respective known context may stay the same and the learning phase may fully or partly become a matter of verifying and/or adjust the methods for determining the present context in view of the perhaps new or changed information sources available on the new apparatus.

It is also possible with a more dynamic learning, or training, phase or mode that e.g. may involve a user of the apparatus. This may be instead or in addition to the above "pre-use" learning phase. Such more dynamic learning phase may involve that the user, e.g. via an interface of the apparatus, selects and/or adjust one or more parameters in certain known contexts and/or identifies when the apparatus is located in a certain known contexts.

**Figure 4** is a schematic block diagram depicting **a first DRC 420** as a first example of an implementation of loudness control. The first DRC 420 may be comprised in or correspond to the loudness control 120 and may be used with embodiments herein. The DRC 220 corresponds to an architecture popular for implementation in Digital Signal Processors (DSP). The first DRC 420 comprises **a synchro delay block 421, a modulated gain block 422, an envelope detection block 423** and **a gain processing block 424.** When compression is not applied, e.g. for low level signals, the modulated gain applied by the modulated gain block 422 is constant, e.g. 0 dB. When compression is applied, e.g. in a rate 3:1, the applied gain may be set so that when a gain of e.g. 6 dB is observed for the input signal, a gain of 2 dB only is observed for the output signal. Operation of the DRC 420 involves continuous estimation of the envelope, i.e. the level, of the input signal. The envelop detection may be processed either in an amplitude domain, e.g. peak limiting, or in a power domain, e.g. RMS limiting. RMS based envelop detection is typically more advantageous for embodiments herein. In the context of embodiments herein, the apparatus 100, 110, 150, 160 may provide the one or more parameters, e.g. as determined in Action 205 above, to the gain processing block 424 of the DRC 420. The one or more parameters may e.g. correspond to a value informing about a desired resulting compression rate and may, as mentioned above, have been determined based on the present context of the audio rendering. The gain processing block 422 may in turn be configured to, based on the one or more parameters and input from the envelope detection block 423, control the modulated gain block 422 so that the loudness is controlled to accomplish the desired resulting compression rate according to the one or more parameters.

**Figure 5** is a schematic block diagram depicting **a second DRC 520** as second example of an implementation of loudness control. The second DRC 520 may be comprised in or correspond to the loudness control 120 and may be used for implementation of embodiments herein. This is an alternative to the architecture according to first DRC 420. However, typically an architecture as for the second DRC 520 is less appropriate for digital implementation due to presence of an incompressible delay in the shown feedback loop. In any case, the second DRC 520 comprises **a modulated gain block 521, an envelope detection block 522** and **a gain processing block 523**. Similar as above for the DRC 420 in Figure 4, in the context of embodiments herein, the apparatus 100, 110, 150, 160 may provide the one or more parameters, e.g. as determined in Action 205 above, to the gain processing block 523 that may be configured correspondingly as the gain processing block 424.

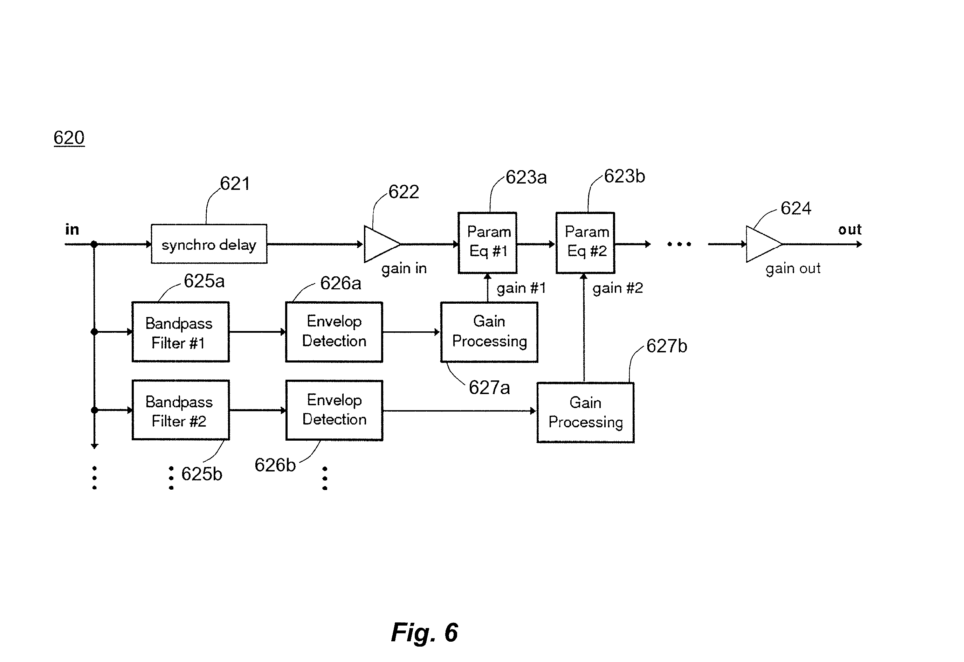

**Figure 6** is a schematic block diagram depicting **a third DRC 620** as third example of an implementation of loudness control. The third DRC 320 may be comprised in or correspond to the loudness control 120 and may be used for implementation of embodiments herein. More specifically the third example is in the form of an example model of a so called multi-band DRC (mDRC). The third DRC 620 includes a band-pass filtering at an envelope detection stage and a notch filter modulated in gain, i.e. a simple form of a parametric equalizer that replaces the modulated gain in the DRCs in Figures 4-5.. The third DRC 620 comprises **a synchro delay block 621, an input gain block 622,** multiple **parametric equalizer blocks 623a-b, an output gain block 624,** multiple **bandpass filter blocks 625a-b, multiple envelope detection blocks 626a-b** and multiple **gain processing blocks 627a-b**. The architecture according to DRC 620 is typically used in order to target and compress a specific spectral band. The shown architecture comprises a repetitive structure with branches, each associated with a respective frequency band, as shown in the figure, which is why it is called mDRC. The mDRC is very versatile and may be configured to simultaneously apply different compression rates on different frequency bands. It is well suited to perform loudness control operations and particular suitable to use with embodiments herein. Different compression rates may beneficially be applied to different frequency bands owing to the aforementioned masking effect that allow environmental noise and/or loudness to be different on different frequency bands. Similar as above for the DRCs 420, 520 in Figures 4-5, in the context of embodiments herein, the apparatus 100, 110, 150, 160 may provide the one or more parameters, e.g. as determined in Action 205 above, to the multiple gain processing blocks 627a-b, one per branch, that may be configured correspondingly as the gain processing blocks 424, 523, but here thus with the possibility to handle different frequency bands differently.

Other alternative implementations of mDRC that may be used with embodiments herein include for example parallel connections of parametric equalizers configured in a passband and combinations between serial and parallel equalizers.

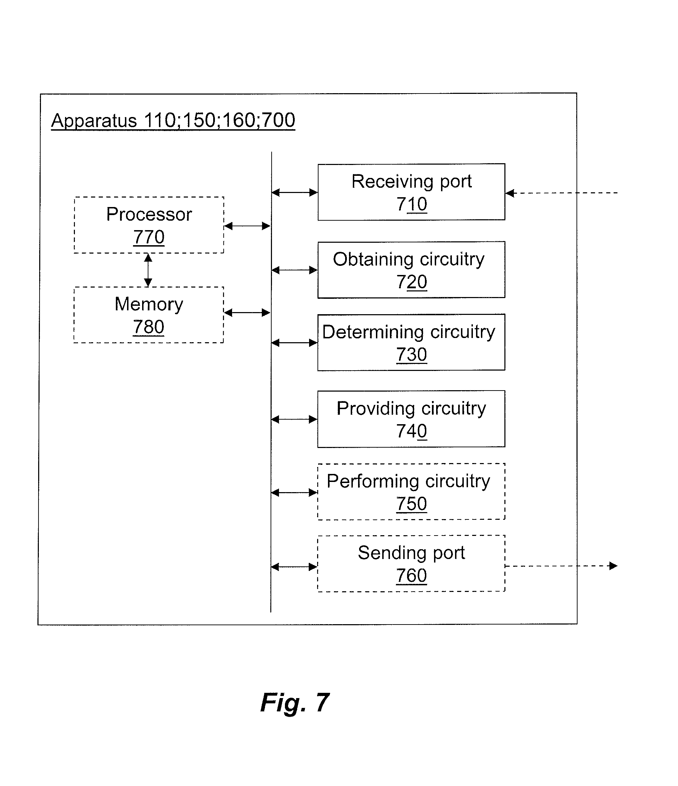

To perform the actions 201-207 above for loudness control at audio rendering of the audio signal, an apparatus 700, e.g. corresponding to or comprising any of the apparatuses 110, 150, 160 and the device 100, may comprise an arrangement schematically depicted in **Figure 7****.**

The apparatus 700 comprises **an obtaining circuitry 720** configured to obtain the information informing about the different circumstances associated with the present context of the audio rendering.

The apparatus 700 further comprises **a determining circuitry 730** configured to, based on the obtained information, determine the one or more parameters associated with the present context. In some embodiments, the determination circuitry 730 is configured to determine the one or more parameters based on the fusion of data comprised in the obtained information originating from the sources, e.g. the multimodal sources 110 and/or the information sources 301-311. Moreover, in some embodiments the determining circuitry 730 is configured to determine the present context based on the obtained information and to determine the one or more parameters based on the determined present context.

In some embodiments, the obtained information comprises the first subset of the information and the determining circuitry 730 is further configured to determine, based on the first subset, potential contexts, and to determine the present context based on the determined potential contexts. Also, in some embodiments the obtained information comprises the second subset of the information and the determining circuitry 730 is configured to determine the present context and/or the potential contexts in response to that the second subset of the information informs about the one or more circumstances indicating the change of the present context. In some embodiments, the determining circuitry 730 is further configured to, for the determination of the present context and/or the potential context, process the first subset and/or the second subset of the information based on the first algorithm that requires less power consumption than the second algorithm for processing a remainder of the obtained information for the determination of the present context.

Moreover, the apparatus 700 comprise **a providing circuitry 740** configured to provide the determined one or more parameters to the audio rendering circuitry, e.g. the audio rendering circuitry 140, configured to control the loudness of the audio rendering of the audio signal based on the one or more parameters.

In some embodiments, the apparatus 700 further comprises **a performing circuitry 750** configured to perform the audio rendering based on the provided one or more parameters. Moreover, ins some embodiments, the obtaining circuitry 720 is configured to obtain the information, and/or the determining circuitry 730 is configured to determine the one or more parameters, in response to a signal for controlling audio volume that is received by the apparatus.

The apparatus 700 may also comprise **a receiving port 710** configured to be involved in communication with other apparatuses or devices. For example, when the apparatus corresponds to the first apparatus 110, the receiving port 710 may be configured to receive at least part of the information from the multimodal sensors 130.

The apparatus 700 typically also comprise **a sending port 760** configured to be involved in communication with other apparatuses and devices. For example, when the apparatus corresponds to the first or second apparatus 110, 150, the sending port 760 may be configured to send the one or more parameters to the audio rendering circuitry 140.

The embodiments of the apparatus 700 may be implemented through one or more processors, such as **a processor 770** depicted in Figure 7, together with computer program code for performing the functions and actions of embodiments herein. In some embodiments the circuitry discussed above may be fully or partially implemented by the processor 770.

The computer program code mentioned above may also be provided as a computer program product, for instance in the form of a data carrier carrying computer program code for performing the embodiments herein when being loaded into the in the apparatus. One such carrier may be in the form of a CD or DVD. It is however feasible with other data carriers such as a memory stick, memory card or hard drive. The computer program code may furthermore be provided as pure program code on a server for download to the apparatus. The computer program code may furthermore be provided in the form of a data file or files on, or available through, a server for download. The file or files may be executable files for direct or indirect download to and execution on the apparatus, or may be for intermediate download and compilation to make them executable before download to and for execution in the apparatus 700. The server may be accessible over a computer network, such as the Internet, and may e.g. be a web or ftp server.

The apparatus 700 may further comprise a **memory 780** comprising one or more memory units. The memory 780 is arranged to store data, such as the indicator, the threshold, and/or configurations and/or applications to perform the method when being executed in the apparatus.

Those skilled in the art will also appreciate that the circuitry and ports 710-760 may refer to a combination of analog and digital circuits, and/or one or more processors configured with software and/or firmware (e.g., stored in memory) that, when executed by the one or more processors such as the processor 770, perform as described above. One or more of these processors, as well as the other digital hardware, may be included in a single application-specific integrated circuit (ASIC), or several processors and various digital hardware may be distributed among several separate components, whether individually packaged or assembled into a system-on-a-chip (SoC).

As should be understood, embodiments herein enable increase of the loudness and the intelligibility of an audio content in a noisy environment, such as public transportation, city streets, cars, while at the same time the risk for damaging the ears with unnecessary high levels is limited. Embodiments described herein also enable improvement of the intelligibility of speech to be rendered on a phone in a noisy environment, e.g., in a noisy environment communication mode of a phone. Moreover, automatic or semi-automatic context aware loudness adaptation is enabled by embodiments herein. This is very beneficial since dynamic range compression concepts are not well understood by the public. Embodiments herein also enable loudness adaptation and processing that are transparent to a user. The user may e.g. be able to adjust setting and activate/deactivate any functionality, in e.g. a smart phone, that implements any of the embodiments herein. Enabling such transparency may be very beneficial in view of the moderate success for use of DRC processing on DVD-players. Furthermore, embodiments herein enable dynamic compression rate processing at audio rendering on e.g. mobile equipment, and may be an important contribution against the infamous loudness war, as mentioned in the Background.

The embodiments herein are not limited to the above described examples. Various alternatives, modifications and equivalents may be used. Therefore, this disclosure should not be limited to the specific form set forth herein. This disclosure is limited only by the appended claims and other embodiments than the mentioned above are equally possible within the scope of the claims.

## Claims

1. A method in an apparatus (100, 110, 150, 160, 700) for loudness control at audio rendering of an audio signal, the method comprising:
- obtaining (201) information informing about different circumstances associated with a present context of the audio rendering,
- determining (204), based on the obtained information, one or more parameters associated with the present context, and
- providing (205) the determined one or more parameters to an audio rendering circuitry (140) configured to control loudness of the audio rendering of the audio signal based on the one or more parameters.

2. The method as claimed in claim 1, wherein the obtained information originates from multiple sources (130, 301-311) of different type.

3. The method as claimed in claim 2, wherein the obtained information comprises raw data and/or pre-processed data originating from the sources (130, 301-311).

4. The method as claimed in any one of claims 2-3, wherein the sources (130, 301-311) comprise one or more sensors (130, 302-307) configured to sense at a location of the audio rendering and provide at least part of the raw data and/or pre-processed data.

5. The method as claimed in any one of claims 2-4, wherein the determination of the one or more parameters is based on fusion of data comprised in the obtained information originating from the sources (130, 301-311).

6. The method as claimed in any one of claims 1-5, wherein the different circumstances that the information informs about relate to one or more of the following:
location associated with the audio rendering,
activity of a device (100, 140, 160) configured to carry out the audio rendering,
time and/or date associated with the audio rendering,
interaction between the device (100, 140, 160) configured to carry out the audio rendering and a user of said device,
motion and/or orientation of the device (100, 140, 160) configured to carry out the audio rendering,
ambient sound at a location associated with the audio rendering,
ambient light at a location associated with the audio rendering,
ambient temperature at a location associated with the audio rendering,
air pressure at a location associated with the audio rendering,
humidity at a location associated with the audio rendering, and
communication to and/or from the apparatus (100, 110, 150, 160, 700) and/or the device (100, 140, 160) configured to carry out the audio rendering.

7. The method as claimed in any one of claims 1-6, wherein the method further comprises:
- determining (203) the present context based on the obtained information, wherein the one or more parameters are determined based on the determined present context.

8. The method as claimed in claim 7, wherein the obtained information comprises a first subset of the information and the method further comprises:
- determining (202), based on the first subset, potential contexts, and
wherein the present context is determined based on the determined potential contexts.

9. The method as claimed in any one of claims 7-8, wherein the obtained information comprises a second subset of the information and the present context and/or the potential contexts are determined in response to that the second subset of the information informs about one or more circumstances indicating a change of the present context.

10. The method as claimed in any one of claims 8-9, wherein the first subset and/or the second subset of the information originates from one or more of the sources (130, 305) operated with a power consumption that is lower than when one or more of the sources (130, 301-311) are operated to provide a remainder of the obtained information.

11. The method as claimed in any one of claims 8-10, wherein the first subset and/or the second subset of the information are processed for the determination of the present context and/or the potential context based on a first algorithm that requires less power consumption than a second algorithm for processing a remainder of the obtained information for the determination of the present context.

12. The method as claimed in any one of claims 1-11, wherein the audio rendering comprises to control a dynamic range of the audio signal based on the one or more parameters.

13. The method as claimed in any one of claims 1-12, wherein the method further comprises:
- performing (506) the audio rendering based on the provided one or more parameters and the audio signal.

14. The method as claimed in claim 13, wherein the information is obtained and/or the one or more parameters are determined in response to a signal for controlling audio volume that is received by the apparatus (100, 110, 150, 160, 700).

15. An apparatus (100, 110, 150, 160, 700) for loudness control at audio rendering of an audio signal, wherein the apparatus (100, 110, 150, 160, 700) comprises:
*an obtaining circuitry (720)* configured to obtain information informing about different circumstances associated with a present context of the audio rendering,
*a determining circuitry (730)* configured to, based on the obtained information, determine one or more parameters associated with the present context, and
*a providing circuitry (740)* configured to provide the determined one or more parameters to an audio rendering circuitry (140), which audio rendering circuitry (140) is configured to control loudness of the audio rendering of the audio signal based on the one or more parameters.

16. The apparatus as claimed in claim 15, wherein the obtained information originates from multiple sources (130, 301-311) of different type.

17. The apparatus as claimed in claim 16, wherein the obtained information comprises raw data and/or pre-processed data originating from the sources (130, 301-311).

18. The apparatus as claimed in any one of claims 16-17, wherein the sources (130, 301-311) comprise one or more sensors (130, 302-307) configured to sense at a location of the audio rendering and provide at least part of the raw data and/or pre-processed data.

19. The apparatus as claimed in any one of claims 16-18, wherein the determination circuitry (730) is configured to determine the one or more parameters based on fusion of data comprised in the obtained information originating from the sources (130,301-311).

20. The apparatus as claimed in any one of claims 16-19, wherein the different circumstances that the information informs about relate to one or more of the following:
location associated with the audio rendering,
activity of a device (100, 140, 160) configured to carry out the audio rendering, time and/or date associated with the audio rendering,
interaction between the device (100, 140, 160) configured to carry out the audio rendering and a user of said device,
motion and/or orientation of the device (140, 160) configured to carry out the audio rendering,
ambient sound at a location associated with the audio rendering,
ambient light at a location associated with the audio rendering,
ambient temperature at a location associated with the audio rendering,
air pressure at a location associated with the audio rendering,
humidity at a location associated with the audio rendering, and
communication to and/or from the apparatus (110, 150, 160) and/or the device (100, 140, 160) configured to carry out the audio rendering.

21. The apparatus as claimed in any one of claims 16-20, wherein the determining circuitry (730) is further configured to determine the present context based on the obtained information and to determine the one or more parameters based on the determined present context.

22. The apparatus as claimed in claim 21, wherein the obtained information comprises a first subset of the information and the determining circuitry (730) is further configured to determine, based on the first subset, potential contexts, and to determine the present context based on the determined potential contexts.

23. The apparatus as claimed in any one of claims 21-22, wherein the obtained information comprises a second subset of the information and the determining circuitry (730) is configured to determine the present context and/or the potential contexts in response to that the second subset of the information informs about one or more circumstances indicating a change of the present context.

24. The apparatus as claimed in any one of claims 22-23, wherein the first subset and/or the second subset of the information originates from one or more of the sources (130, 305) operated with a power consumption that is lower than when one or more of the sources (130, 301-311) are operated to provide a remainder of the obtained information.

25. The apparatus as claimed in any one of claims 22-24, wherein the determining circuitry (730) is further configured to, for the determination of the present context and/or the potential context, process the first subset and/or the second subset of the information based on a first algorithm that requires less power consumption than a second algorithm for processing a remainder of the obtained information for the determination of the present context.

26. The apparatus as claimed in any one of claims 16-25, wherein the audio rendering comprises to control a dynamic range of the audio signal based on the one or more parameters.

27. The apparatus as claimed in any one of claims 16-26, wherein the apparatus further comprises:
*a performing circuitry (750)* configured to perform the audio rendering based on the provided one or more parameters.

28. The apparatus as claimed in claim 27, wherein the obtaining circuitry (720) is configured to obtain the information, and/or the determining circuitry (730) is configured to determine the one or more parameters, in response to a signal for controlling audio volume that is received by the apparatus (100, 110, 150, 160, 700).
